# EUROPÄISCHE PATENTSCHRIFT

(11) **EP 4 308 946 B1**
(45) Veröffentlichungstag und Bekanntmachung des Hinweises auf die Patenterteilung: **06.05.2026**
(21) Anmeldenummer: 22717112.1
(22) Anmeldetag: 21.03.2022
(51) Int. Cl.: G01R 31/52, G01R 31/36, B60L 3/00, G01R 31/00, G01R 27/02

(54) **VERFAHREN ZUM ÜBERPRÜFEN EINES ISOLATIONSZUSTANDS EINER BATTERIE ODER EINES BATTERIESYSTEMS**
METHOD FOR CHECKING THE STATE OF ISOLATION OF A BATTERY OR OF A BATTERY SYSTEM
PROCÉDÉ DE CONTRÔLE D'UN ÉTAT D'ISOLATION D'UNE BATTERIE OU D'UN SYSTÈME DE BATTERIES

(30) Priorität: 19.03.2021 DE 102021106891
(43) Veröffentlichungstag der Anmeldung: 24.01.2024
(73) Patentinhaber: Webasto SE, 82131 Stockdorf (DE)
(72) Erfinder: NOWROTH, Julian, 82131 Stockdorf (DE); LIU ZHU, Ivan, 82131 Stockdorf (DE)
(74) Vertreter: Nordmeyer, Philipp Werner
(86) Internationale Anmeldenummer: PCT/EP2022/057306
(87) Internationale Veröffentlichungsnummer: WO 2022/195125

(56) Entgegenhaltungen:
- WO-A1-2011/018910
- US-A1- 2007 176 604
- US-A1- 2012 206 152
- US-A1- 2016 252 587

## Beschreibung

### Technisches Gebiet

Die vorliegende Erfindung betrifft ein Verfahren zum Überprüfen eines Isolationszustands einer Batterie oder eines Batteriesystems, bevorzugt einer Hochspannungsbatterie oder eines Hochspannungsbatteriesystems zur Verwendung als Traktionsbatterie eines elektrischen Fahrzeugs oder zur Verwendung in stationären Speicheranwendungen, sowie eine entsprechende Vorrichtung.

### Stand der Technik

Die Verwendung von Hochspannungsbatterien, beispielsweise für elektrische Fahrzeuge, erfordert eine Überprüfung des Isolationszustands der Hochspannungsbatterie, bevor diese eingeschaltet oder zu einem Batteriesystem zusammengeschaltet werden, um dann an eine Last angeschlossen zu werden. So liegt in einem Normalzustand in einem elektrischen Fahrzeug, in dem die Hochspannungsbatterie bevorzugt als Traktionsbatterie angeordnet ist, eine galvanische Trennung zwischen der Hochspannungsbatterie und der Masse beziehungsweise dem Chassis vor, sodass beim Einschalten der Hochspannungsbatterie kein Kurzschluss entsteht und sichergestellt werden kann, dass der Benutzer keinem ggf. lebensbedrohlichen elektrischen Schock ausgesetzt wird und auch die übrige Elektronik des Fahrzeugs nicht beschädigt wird. Wenn Hochspannungsbatterien zu einem Hochspannungsbatteriesystem zusammengeschaltet werden, ist es von besonderer Bedeutung, dass die zusammenzuschaltenden Hochspannungsbatterien gegenüber der Masse isoliert sind, da sonst bereits beim Zusammenschalten der Hochspannungsbatterien ein Kurzschluss über die Masse entstehen könnte und es so zu unkontrolliert hohen Strömen und damit zu einer Zerstörung der Hochspannungsbatterien und einer Gefährdung des Benutzers kommen könnte.

Eine Isolationsüberprüfung erfolgt üblicherweise anhand eines berechneten Isolationswiderstands zwischen der Hochspannungsbatterie und Masse, beispielsweise dem Chassis eines elektrischen Fahrzeugs, nach dem Anlegen einer hohen Spannung bei einem geringen Strom. Für die zuverlässige Berechnung ist erforderlich, dass eine stabile Spannung, also eine Spannungssättigung, gemessen wird, welche jedoch erst nach einer längeren Zeit eintritt, beispielsweise nach etwa 7 bis 10 Sekunden. Entsprechend kann die Überprüfung insbesondere, wenn diese für mehrere Anschlüsse oder Leitungen der Hochspannungsbatterie erfolgt, und je nach Konfiguration der Hochspannungsbatterie und der Hardware- und Softwareebene, bis 30 Sekunden oder sogar mehr benötigen. Eine so lange Zeit zum Starten eines Fahrzeugs ist unerwünscht. Das Verkürzen dieser Überprüfungszeit für einen jeweiligen Anschluss beeinträchtigt aber dabei die Genauigkeit und den messbaren Bereich des berechneten Widerstands.

Gleichwohl gilt, dass es für den Benutzer der Hochspannungsbatterie beziehungsweise eines elektrischen Fahrzeugs grundsätzlich unerwünscht ist, längere Überprüfungszeiten zum Bestimmen des Isolationszustands abzuwarten, da dies zu einem (erheblichen) Verzug der jeweiligen Verwendung der Hochspannungsbatterie und damit der Verwendung des Fahrzeugs führt.

Aus US 2012/0206152 A1 ist eine Vorrichtung zum Erfassen einer elektrischen Leckage bekannt, wobei eine gemessene absolute Spannung eines eingekoppelten Pulses mit einem Schwellenwert verglichen wird.

Es besteht somit ein Bedarf, die Sicherheit des Benutzers zu gewährleisten und dennoch eine rasche Isolationsüberprüfung bereitzustellen.

### Darstellung der Erfindung

Ausgehend von dem bekannten Stand der Technik ist es eine Aufgabe der vorliegenden Erfindung, ein verbessertes Verfahren zum Überprüfen eines Isolationszustands einer Batterie, sowie ein entsprechendes Überprüfungsmodul und ein entsprechendes System bereitzustellen.

Die Aufgabe wird durch ein Verfahren zum Überprüfen eines Isolationszustands einer Batterie mit den Merkmalen des Anspruchs 1 gelöst. Vorteilhafte Weiterbildungen ergeben sich aus den Unteransprüchen, der Beschreibung und den Figuren.

Entsprechend wird ein Verfahren zum Überprüfen eines Isolationszustands einer Batterie, bevorzugt einer Batterie eines Batteriesystems und besonders bevorzugt einer Hochspannungsbatterie, vorgeschlagen, umfassend die Schritte:
- Messen einer elektrischen Spannung, U, zwischen einem Anschlusselement der Batterie und einer Masse über eine vorgegebene Zeit, t;
- Auswerten der gemessenen Spannung und Feststellen, ob zu einem Zeitpunkt, welcher einem vorgegebenen zeitlichen Schwellenwert entspricht, eine gemessene Spannungsänderung dU/ dt vorliegt; und
- Ausgeben eines für den Isolationszustand kennzeichnenden Sicherheitssignals in Abhängigkeit des Feststellungsergebnisses.

Erfindungsgemäß wurde erkannt, dass die Sättigungszeit der Spannung von der vorhandenen Kapazität und dem vorhandenen Widerstand abhängig ist. Im Falle eines Isolationsfehlers, bei dem ein geringer Widerstand vorliegt, oder bei einer geringen parasitären Kapazität tritt eine rasche Spannungssättigung ein. Gleichermaßen gilt, dass wenn die Spannungssättigung eingetreten ist, keine Spannungsänderung mehr gemessen wird.

Das vorgeschlagene Verfahren ermöglicht entsprechend, dass ein zeitlicher Schwellenwert festgelegt beziehungsweise vorgegeben wird, welcher ein Maß für den Isolationszustand ist und insbesondere so gewählt wird, dass gravierende Isolationsfehler anhand des zeitlichen Schwellenwerts ermittelt beziehungsweise bestimmt werden können. So tritt im Falle eines Kurzschlusses oder einer fehlerhaften Isolation eine rasche Sättigung der gemessenen Spannung ein. Wird zu einem Zeitpunkt, welcher dem zeitlichen Schwellenwert entspricht, keine Spannungsänderung mehr gemessen beziehungsweise erfasst, so wird angenommen, dass eine Spannungssättigung bereits eingetreten ist und entsprechend kann das Sicherheitssignal auf einen Isolationsfehler deuten. Umgekehrt werden (gravierende) Isolationsfehler mit hinreichender Wahrscheinlichkeit ausgeschlossen, wenn zum Zeitpunkt des zeitlichen Schwellenwerts noch eine Spannungsänderung gemessen beziehungsweise erfasst wird und entsprechend noch keine Spannungssättigung eingetreten ist.

Der zeitliche Schwellenwert kann somit einem bestimmten Sicherheitsmaß und/oder einem vorgegebenen Isolationszustand beziehungsweise Isolationsfehler entsprechen. Die Verwendung des zeitlichen Schwellenwerts hat somit den Vorteil, dass für bestimmte Isolationsfehler, keine vollständige standardmäßige Überprüfung und Berechnung des Widerstands erfolgen muss. Stattdessen können diese Isolationsfehler bereits nach kurzer Zeit anhand einer gemessenen Spannungsänderung zum Zeitpunkt des zeitlichen Schwellenwerts ausgeschlossen beziehungsweise ermittelt werden. So tritt beispielsweise bei einer fehlerhaften galvanischen Trennung zwischen der Batterie und einem die Masse repräsentierenden Chassis eines elektrischen Fahrzeugs eine Spannungssättigung bereits innerhalb des zeitlichen Schwellenwerts ein.

Auf diese Weise wird die Überprüfungszeit des Isolationszustands für das Anschlusselement, im Wesentlichen durch den zeitlichen Schwellenwert vorgegeben und diese kann, je nach Konfiguration der Batterie und dem festgelegten Schwellwert für einen Isolationsfehler (beispielsweise 500Ohm/Volt), zwischen etwa 0,3 Sekunden und 2 Sekunden, insbesondere zwischen 0,4 Sekunden und 0,8 Sekunden betragen. Dadurch wird die Wartezeit für den Benutzer erheblich verringert beziehungsweise ist diese für den Benutzer nicht signifikant wahrnehmbar, sodass unerwünschte Wartezeiten verhindert werden können und keine wesentliche Verzögerung der Anwendung gegeben ist. Gleichwohl wird eine hinreichende Sicherheit für den Benutzer gewährleistet, zumal der zeitliche Schwellenwert beispielsweise für ein bestimmtes Sicherheitsmaß und/oder einen vorgegebenen Isolationsfehler maßgebend ist.

Die Masse kann jegliche Masse sein, welche eine Erdung oder Nullung ermöglicht. Im Falle einer Batterie für ein elektrisches Fahrzeug kann die Masse insbesondere das Chassis des elektrischen Fahrzeugs sein. Alternativ kann jedoch auch ein leitfähiges Gehäuse mit entsprechenden Eigenschaften gewählt werden. Bevorzugt ist die Batterie dabei eine Traktionsbatterie eines elektrischen Fahrzeugs. Die Isolationsüberprüfung kann dabei insbesondere als Sicherheitsstufe für eine Schaltvorrichtung dienen, welche dazu eingerichtet ist, die Batterie mit einer Last, beispielsweise dem Bordnetz und/oder einem Elektromotor zu verbinden, beispielsweise über eine entsprechende schaltbare Trennvorrichtung. Das Sicherheitssignal kann somit einen hinreichenden Isolationszustand bestätigen oder auf das Vorliegen eines (gravierenden) Isolationsfehlers hindeuten, sodass die Schaltvorrichtung in Abhängigkeit dieses Ergebnisses geschaltet werden kann. Mit anderen Worten, kann durch die Ausgabe des Sicherheitssignals die Schaltvorrichtung betätigt beziehungsweise geschlossen werden, aber nur dann, wenn kein (gravierender) Isolationsfehler festgestellt wurde.

Die hier genannte Batterie kann bevorzugt auch zum Aufbau eines Batteriesystems vorgesehen sein, wobei zum Aufbau des Batteriesystems mindestens zwei Batterien zusammengeschaltet werden, um auf diese Weise eine erhöhte Kapazität des kombinierten Batteriesystems bereit zu stellen. Das Batteriesystem dient dann dazu, die Last mit elektrischer Energie zu versorgen. Als Batterie kann bevorzugt eine Hochspannungsbatterie vorgesehen sein, die dann mit mindestens einer weiteren Hochspannungsbatterie zu einem Hochspannungsbatteriesystem zusammengeschaltet werden kann und dann beispielsweise zur Verwendung als Traktionsbatterie eines elektrischen Fahrzeugs oder zur Verwendung in stationären Speicheranwendungen eingesetzt werden kann. Das Sicherheitssignal kann somit einen hinreichenden Isolationszustand bestätigen oder auf das Vorliegen eines (gravierenden) Isolationsfehlers so hindeuten, dass eine Schaltvorrichtung zum Zusammenschalten der Batterien beziehungsweise der Hochspannungsbatterien in Abhängigkeit dieses Ergebnisses geschaltet werden kann. Mit anderen Worten kann durch die Ausgabe des Sicherheitssignals die Schaltvorrichtung betätigt beziehungsweise geschlossen werden, aber nur dann, wenn kein (gravierender) Isolationsfehler festgestellt wurde. Wurde hingegen ein (gravierender) Isolationsfehler festgestellt, kann die entsprechende Batterie nicht zum Batteriesystem hinzugeschaltet werden oder die Batterien des gesamten Batteriesystems können nicht zusammengeschaltet werden beziehungsweise können nicht mit der Last verbunden werden.

Das Anschlusselement kann eine Anschlussleitung der Batterie oder auch ein Pol oder ein entsprechendes Kontaktelement der Batterie sein.

Bevorzugt umfasst die Batterie mindestens zwei Batteriemodule. Mit anderen Worten ist eine Batterie bevorzugt aus mindestens zwei Batteriemodulen aufgebaut, die ihrerseits wiederum aus einer Mehrzahl von Batteriezellen, die beispielsweise als zylindrische oder prismatische Batteriezellen vorgesehen sein können oder als Pouchzellen vorliegen können, aufgebaut sind. Die Batterie ist besonders bevorzugt mit einem eigenen Batteriegehäuse versehen, in welchem die Batteriemodule fluiddicht und gegenüber der Umgebung geschützt aufgenommen sind. Die Batterie umfasst dabei bevorzugt auch Einrichtungen zur Temperierung der in den Batteriemodulen organisierten Batteriezellen. Jede Batterie weist einen Hauptanschluss mit zwei Verbindungskontakten auf, an welchem die gesamte Kapazität der Batterie anliegt. Jede Batterie weist eine Trennvorrichtung auf, die den Hauptanschluss spannungsfrei schalten kann. Mittels der Trennvorrichtung wird die Batterie dann mit der Last verbunden beziehungsweise dem Batteriesystem zugeschaltet.

Zum Aufbau eines Batteriesystems werden mindestens zwei Batterien zusammengeschaltet, die beispielsweise an zwei unterschiedlichen Orten in dem Fahrzeug angeordnet sind - beispielsweise eine Batterie im Unterflurbereich des Fahrzeugs und eine weitere Batterie im Heck des Fahrzeugs. Vor dem Zusammenschalten der Batterien zu dem Batteriesystem muss der Isolationszustand der Batterien überprüft werden, um einen Kurzschluss über die gemeinsame Masse zu verhindern.

Im Falle von zwei Batterien kann beispielsweise der Isolationszustand anhand der vier elektrischen Verbindungskontakte oder der daran angeschlossenen Verbindungsleitungen überprüft werden. Bevorzugt wird jedoch, dass der Isolationszustand für jeden Verbindungskontakt einer jeden Batterie separat gemessen und ausgewertet wird.

Bei Batteriesystemen mit mehreren, elektrisch verbundenen Batterien tritt weiterhin aufgrund der Kontaktierung und der Leitungen eine parasitäre Kapazität zwischen den Batterien auf. Die Batterien selbst tragen auch eine parasitäre Kapazität in sich. Im normalen Zustand, bei dem kein Isolationsfehler vorliegt, ist diese im Verhältnis zu einem Isolationszustand, bei dem ein Kurzschluss vorliegt, signifikant höher. Mit anderen Worten ist die parasitäre Kapazität im Falle eines (gravierenden) Isolationsfehlers relativ klein. Dies ermöglicht, dass der zeitliche Schwellenwert entsprechend vorgegeben sein kann, um zwischen diesen Zuständen zu differenzieren, zumal sich dies unmittelbar auf die Sättigungszeit der gemessenen Spannung auswirkt.

Entsprechend kann das Batteriesystem mindestens zwei Batterien umfassen, wobei der zeitliche Schwellenwert von einer vorgegebenen parasitären Kapazität und einem vorgegebenen Widerstand bestimmt wird.

Beispielsweise kann für eine Batterie im Normalzustand eine maximale parasitäre Kapazität von etwa 900 nF vorliegen, d.h. etwa 450 nF für jede elektrische Verbindungsleitung. Der Widerstand kann zudem beispielsweise auf 100 kOhm oder 150 kOhm angenommen werden, um eine hinreichende Sicherheit bereitzustellen und beispielsweise einen vorhandenen Kurzschluss innerhalb der vorgegebenen Zeit mit hinreichender Sicherheit zu erfassen. Anhand dieser Werte der maximalen parasitären Kapazität und des Widerstands wird entsprechend eine Sättigungszeit für die gemessene Spannung bestimmt beziehungsweise berechnet. Dabei kann bei einer Anwendung als Batteriesystem für ein elektrisches Fahrzeug das Chassis als Masse dienen, welche zur Berechnung des zeitlichen Schwellenwerts beispielsweise mit einem Widerstand von etwa 500 kOhm festgelegt wird. Die Spannung des Batteriesystems beziehungsweise der Batterien ist dabei beispielsweise etwa 400 V oder 800V. Mit den vorstehend beschriebenen Werten liegt der berechnete zeitliche Schwellenwert beziehungsweise die entsprechende maximale Sättigungszeit etwa zwischen 0,5 und 0,7 Sekunden.

Wird entsprechend festgestellt, dass noch keine Sättigung der gemessenen Spannung zu einem Zeitpunkt, welcher dem festgelegten zeitlichen Schwellenwert entspricht, vorliegt, so können gravierende Isolationsfehler mit hinreichender Wahrscheinlichkeit ausgeschlossen werden.

Der zeitliche Schwellenwert kann dabei je nach Konfiguration der Batterie und/oder der Hardware- und Softwareebene an eine vorgesehene Abtastrate angepasst werden. Beispielsweise kann der zeitliche Schwellenwert bei einer Abtastrate von 100 ms somit 5 oder 7 Messpunkte umfassen, um einen entsprechenden zeitlichen Schwellenwert zwischen etwa 0,41 Sekunden und 0,5 Sekunden beziehungsweise zwischen etwa 0,61 Sekunden und 0,7 Sekunden zu umfassen. Der zeitliche Schwellenwert kann dabei hinterlegt oder von einer dezentralen oder zentralen Einheit über ein Kommunikationsmodul empfangen werden.

Bevorzugt ist die parasitäre Kapazität batteriespezifisch. Auf diese Weise kann für jede Batterie desselben Typs beziehungsweise derselben Konfiguration derselbe zeitliche Schwellenwert verwendet werden, wodurch das Verfahren auch einfach für bestehende Batterien und Batteriesysteme implementiert werden kann, beispielsweise auf Softwareebene, und auf Hardwareebene keine (erheblichen) Anpassungen und insbesondere keine anwendungsspezifischen oder batteriespezifischen Messungen der jeweiligen parasitären Kapazität erforderlich sind.

Bevorzugt wird die parasitäre Kapazität für die Batterie gemessen und/oder berechnet, wobei die parasitäre Kapazität bevorzugt um einen vorgegebenen Sicherheitsfaktor erhöht wird. Die Messung und/oder Berechnung kann ebenfalls für eine oder mehrere Batterien desselben Typs erfolgen, beispielsweise im Werk, und für Batterien desselben Typs festgelegt werden. Mit anderen Worten ist keine aktive Messung und/oder Berechnung gemäß dem Verfahren erforderlich, sondern es handelt sich bei der parasitären Kapazität um einen Wert, der nicht beliebig oder rein theoretisch festgelegt wird, sondern auf einer tatsächlichen Messung und/oder Berechnung beruht. Bevorzugt wird der Wert für die parasitäre Kapazität sowohl gemessen als auch berechnet, sodass beispielsweise eine Überprüfung des berechneten Werts erfolgt und die Sicherheit bei der Verwendung des davon abhängenden zeitlichen Schwellenwerts weiter erhöht werden kann.

Beispielsweise kann eine berechnete und/oder gemessene parasitäre Kapazität zwischen etwa 100 nF und 300 nF liegen. Diese maximale parasitäre Kapazität kann zur verbesserten Sicherheit um einen entsprechenden Sicherheitsfaktor erhöht werden, sodass die Sicherheit beim Verwenden des entsprechenden zeitlichen Schwellenwerts ebenfalls um diesen Faktor erhöht werden kann. Beispielsweise kann bei einer gemessenen beziehungsweise berechneten parasitären Kapazität von etwa 220 nF eine maximale parasitäre Kapazität von 450 nF gewählt werden, welche der Berechnung des zeitlichen Schwellenwerts entsprechend zugrunde gelegt wird.

Der für den zeitlichen Schwellenwert verwendete Widerstand liegt, je nach Anwendung, bevorzugt zwischen 50 kOhm und 250 kOhm, bevorzugt zwischen 75 kOhm und 175 kOhm. Auf diese Weise kann ein Widerstand verwendet werden, welcher zwar niedriger als in Standardverfahren ist. Solche Widerstandswerte bieten aber dennoch eine hinreichende Sicherheit für den Benutzer und auch für die Batteriemodule, zumal dadurch gravierende Isolationsfehler wie das Vorliegen eines Kurzschlusses festgestellt werden können. Durch den niedrigeren Widerstand kann die Isolationsüberprüfung weiterhin erheblich verkürzt werden.

Der Widerstand ist bevorzugt ein vorgegebener Anfangswiderstand oder ein Nennwiderstand. Somit kann der zeitliche Schwellenwert für unterschiedliche Betriebszustände festgelegt sein.

Um die Genauigkeit des Bestimmens oder Erfassens einer Spannungsänderung zu erhöhen, kann weiterhin vorgesehen sein, dass die Spannungsänderung für die letzten zwei bis fünf Messpunkte bestimmt wird, bevorzugt die letzten zwei oder drei Messpunkte, und/oder wobei eine Spannungsänderung bestimmt wird, wenn diese zumindest eine vorgegebene Mindestgröße aufweist.

Dies ermöglicht, dass eventuell vorhandene Messfehler oder Fluktuationen gemittelt werden können und die Validität des ausgegebenen Sicherheitssignals verbessert werden kann. Ebenfalls ermöglicht die vorgegebene Mindestgröße, dass nur relevante Spannungswerte beim Bestimmen einer Spannungsänderung berücksichtigt werden und erfasste Hintergrundsignale, Restwerte oder Rauschen ausgeblendet werden können. Beispielsweise kann die Mindestgröße zwischen 0,2 V und 1,0 V liegen oder etwa 0,5 V sein, sodass erfasste Messwerte unter 0,5 V nicht als Spannungsänderung erfasst werden.

Alternativ, oder zusätzlich kann das Sicherheitssignal weiterhin in Abhängigkeit eines zum Zeitpunkt gemessenen absoluten Spannungswerts ausgegeben werden. Auf diese Weise kann erfasst werden, ob die gemessene Spannung sich in einem erwarteten und/oder vorgegeben Bereich befindet, sodass die Validität der Messung und der Spannungsänderung weiter erhöht werden können.

Der gemessene absolute Spannungswert kann dabei als valide angesehen werden, wenn dieser beispielsweise im Verhältnis zu einem vorgegebenen maximalem Spannungswert, beispielsweise eines Batteriemoduls, zwischen 10 Prozent und 70 Prozent, bevorzugt zwischen 15 Prozent und 55 Prozent des vorgegebenen maximalen Spannungswerts beträgt.

Beispielsweise kann der gemessene absolute Spannungswert einer Batterie von etwa 400 V zwischen 40 V und 280 V liegen und liegt bevorzugt zwischen 60 V und 220 V. Sollte entsprechend eine Spannungsänderung zum Zeitpunkt des zeitlichen Schwellenwerts festgestellt werden, so bestätigt der absolute Spannungswert die Validität des Feststellungsergebnisses und kann dieser, wenn dieser nicht im vorgegeben Bereich liegt, mittels des ausgegebenen Sicherheitssignals auf einen potenziellen Isolationsfehler oder Messfehler deuten.

Bevorzugt umfasst das Sicherheitssignal bei einer zum Zeitpunkt festgestellten Spannungsänderung ein Betätigungssignal einer Hochspannungsschaltvorrichtung oder das Sicherheitssignal veranlasst in Abwesenheit einer Spannungsänderung eine weitere, insbesondere nach Norm vollständige, Isolationsüberprüfung.

Wie vorstehend beschrieben, kann das Batteriesystem insbesondere als Traktionsbatterie für ein elektrisches Fahrzeug ausgebildet sein und dabei mehrere Batterien umfassen. Um den Benutzer des Fahrzeugs und auch die Batterien vor einem eventuellen Kurzschluss zu schützen, wird der Isolationszustand überprüft, bevor die jeweilige Batterie an eine Last wie das Bordnetz oder einen Elektromotor mittels der Hochspannungsschaltvorrichtung und ggf. einer Trennvorrichtung angeschlossen wird. Sollte zum Zeitpunkt der beziehungsweise während der Messung und bei oder unmittelbar nach dem Eintreten des zeitlichen Schwellenwerts weiterhin eine Spannungsänderung erfasst werden, so wird festgestellt, dass kein (gravierender) Isolationsfehler vorliegt, sodass das Batteriesystem entsprechend an den Verbraucher angeschlossen werden kann und hierzu ein Betätigungssignal ausgegeben wird. Wird jedoch eine bereits eingetretene Spannungssättigung festgestellt, so kann eine Fehlermeldung ausgegeben werden und/oder unmittelbar eine weitere Isolationsüberprüfung, beispielsweise durch ein standardgemäß vorgesehenes Bestimmen des Widerstands, veranlasst werden. Auf diese Weise kann eine weitere Überprüfung beziehungsweise ein alteratives Verfahren zum Bestimmen des Isolationszustands als weitere Sicherheit und als Backup dienen.

Gemäß einem weiteren Aspekt wird ein Überprüfungsmodul zum Überprüfen eines Isolationszustands einer Batterie, bevorzugt einer Traktionsbatterie eines elektrischen Fahrzeugs, vorgeschlagen, welches dazu eingerichtet ist, das beschriebene Verfahren auszuführen.

Das Überprüfungsmodul kann beispielsweise eine Schnittstelle zum Messen und/oder Empfangen einer gemessenen elektrischen Spannung zwischen einem Anschlusselement der Batterie und einer Masse über eine vorgegebene Zeit umfassen. Weiterhin kann das Überprüfungsmodul eine Auswerteeinheit umfassen, welche mit der Schnittstelle verbunden und zum Auswerten der gemessenen Spannung eingerichtet ist, wobei die Auswerteeinheit weiterhin dazu eingerichtet ist, festzustellen, ob eine Änderung der gemessenen Spannung zu einem Zeitpunkt vorliegt, welcher einem vorgegebenen zeitlichen Schwellenwert entspricht. Das Überprüfungsmodul oder die Auswerteeinheit des Überprüfungsmoduls ist weiterhin dazu eingerichtet, ein für den Isolationszustand kennzeichnendes Sicherheitssignal in Abhängigkeit des Feststellungsergebnisses auszugeben.

Die Auswerteeinheit kann eine eigenständige Einheit des Überprüfungsmoduls sein oder zumindest teilweise als Steuer- und Regeleinheit der für die Batterie jeweilige Anwendung sein. Mit anderen Worten können (Teil-)Aufgaben der Auswerteeinheit beispielsweise mittels einer kommunikativen Koppelung mit einer Steuer- und Regeleinheit ausgelagert werden oder die Auswerteeinheit kann in der Steuer- und Regeleinheit integriert sein. Auf diese Weise kann die Auswerteeinheit zumindest teilweise als on-bord Steuer- und Regeleinheit ausgebildet sein.

Der zeitliche Schwellenwert ist weiterhin bevorzugt in der Auswerteeinheit hinterlegt und ist spezifisch für die jeweilige Batterie. Beim Starten der Spannungsmessung für eine vorgegebene Zeit wird zum Zeitpunkt des hinterlegten zeitlichen Schwellenwerts entsprechend festgestellt, ob eine Spannungsänderung vorliegt und das Überprüfungsmodul beziehungsweise die Auswerteeinheit gibt ein entsprechendes Sicherheitssignal aus.

Gemäß einem weiteren Aspekt der Erfindung wird ein Batteriesystem vorgeschlagen, welches mindestens zwei Batterien, bevorzugt zur Ausbildung einer Traktionsbatterie für ein elektrisches Fahrzeug, und ein damit kommunikativ und/oder elektrisch leitfähig gekoppeltes Überprüfungsmodul umfasst.

Das Batteriesystem kann beispielsweise ein on-bord Batteriemanagementsystem umfassen. Das Batteriesystem umfasst mindestens zwei Batterien, welche elektrisch leitfähig miteinander verbindbar sind und wobei jede Batterie mindestens zwei Batteriemodule mit jeweils einer Mehrzahl von Batteriezellen umfasst. Bevorzugt umfasst das Batteriesystem weiterhin eine Hochspannungsschaltvorrichtung, welche dazu eingerichtet ist, in Abhängigkeit eines vom Überprüfungsmodul ausgegebenen Sicherheitssignals die jeweilige Batterie zum Batteriesystem zuzuschalten und damit das Batteriesystem elektrisch leitfähig mit einer Last wie einem Elektromotor oder Steuerung eines Elektromotors zu verbinden.

### Kurze Beschreibung der Figuren

Bevorzugte weitere Ausführungsformen der Erfindung werden durch die nachfolgende Beschreibung der Figuren näher erläutert. Dabei zeigen:
Figuren 1A und 1B eine schematische Darstellung von Isolationsfehlern eines Batteriesystems mit zwei Batterien gegenüber einem Chassis in einem elektrischen Fahrzeug;
Figur 2 ein beispielhafter Spannungsmessungsverlauf im Normalzustand ohne Isolationsfehler in einem herkömmlichen Verfahren; und
Figur 3A und 3B eine schematische Darstellung eines beispielhaften Spannungsmessungsverlaufs ohne beziehungsweise mit Isolationsfehlern.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen versehen, und auf eine wiederholte Beschreibung dieser Elemente wird teilweise verzichtet, um Redundanzen zu vermeiden.

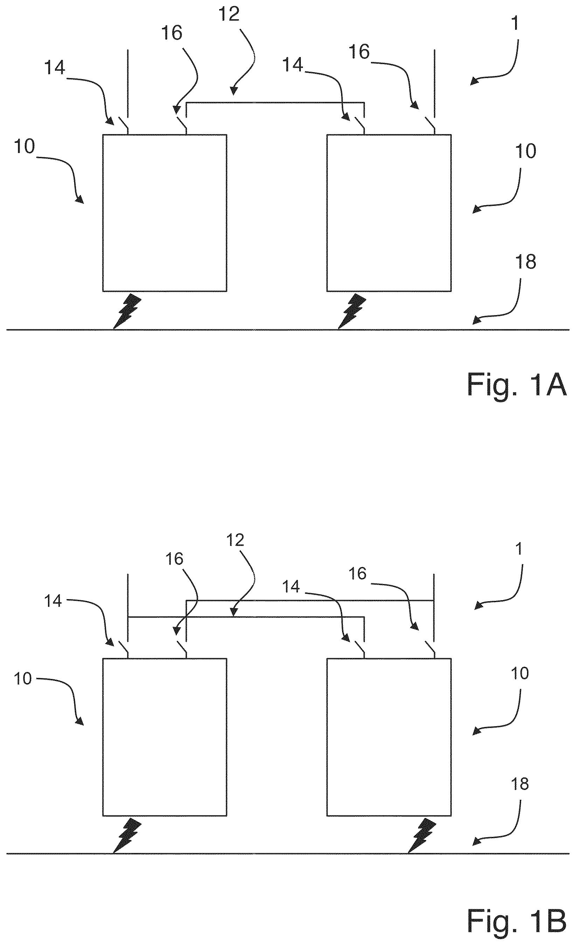

In Figur 1A ist schematisch ein Batteriesystem 1 mit zwei Batterien 10 gezeigt, wobei die Batterien 10 über entsprechende Anschlussleitungen 12 beziehungsweise Anschlusselemente elektrisch leitfähig und in Reihe miteinander verbunden sind. Es sind zudem weitere Anschlussleitungen vorgesehen, um das Batteriesystem beziehungsweise die jeweiligen Batterien 10 mit einer Last elektrisch leitfähig zu verbinden, beispielsweise über eine Trennvorrichtung und/oder eine Hochspannungsschaltvorrichtung (nicht gezeigt). Jede Batterie 10 umfasst weiterhin einen positiven Pol 14 sowie einen negativen Pol 16, welche mittels der entsprechenden Anschlussleitungen elektrisch gekoppelt werden können.

In der beispielhaften Ausführungsform sind vorliegend zwei Isolationsfehler vorhanden, wie mit dem entsprechenden Blitzsymbol dargestellt. In diesem Beispiel ist die Isolation beziehungsweise galvanische Trennung des positiven Pols 14 der jeweiligen Batterie 10 gegenüber dem Chassis 18 (oder anderer Masse) nicht vollständig, sodass die jeweiligen Pole 14 mit dem Chassis 18 elektrisch leitfähig verbunden sind. Schon allein für sich genommen ist ein solcher Isolationsfehler einer individuellen Batterie 10 gegenüber dem Chassis 18 als problematisch anzusehen und sollte vermieden werden.

Im Fall der Bereitstellung eines Batteriesystems 1, bei welchem die Batterien 10 miteinander verbunden werden sollen, besteht jedoch die zusätzliche Gefahr, dass über das Chassis 18 ein Kurzschluss zwischen den Batterien 10 erzeugt wird, der dann zu einem hohen Stromfluss und damit einer Gefährdung der Batterien 10 und des Benutzers führen kann. Beispielsweise kann, wenn über die Isolationsfehler der Batterien 10 eine leitende Verbindung zwischen dem positiven Pol der einen Batterie und dem negativen Pol der anderen Batterie hergestellt wird und dann durch das Schließen der jeweils anderen Pole durch die Hochspannungsschaltvorrichtung, ein hoher Stromfluss unkontrolliert auftreten. Solche Isolationsfehler sind entsprechend zu vermeiden und werden gemäß dem vorgeschlagenen Verfahren ermittelt.

In Figur 1B ist eine parallele Schaltung zwischen den Batterien 10 gezeigt. In diesem Beispiel liegt ein Isolationsfehler am positiven Pol 14 der einen Batterie 10 und ein Isolationsfehler am negativen Pol 16 der anderen Batterie vor, wie mit dem entsprechenden Blitzsymbol gekennzeichnet.

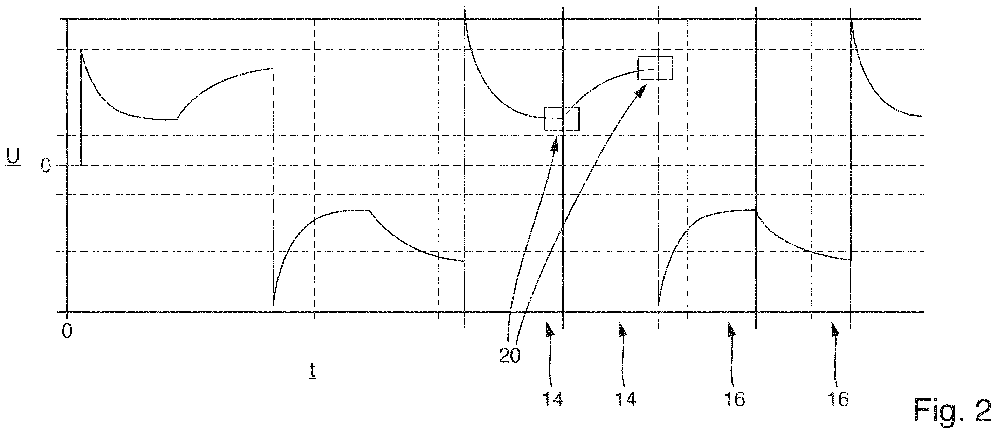

In Figur 2 ist ein beispielhafter Spannungsmessungsverlauf einer herkömmlichen Isolationsmessung im Normalzustand ohne Isolationsfehler dargestellt, wobei eine hohe Spannung U bei einem kleinen Strom zwischen einer Anschlussleitung und der Masse des Fahrzeugs angelegt wird. Die Spannung U (in Volt) wird nun über eine vorgegebene Zeit t (in Sekunden) gemessen. Das Messverfahren stellt ein Standardverfahren dar, wobei in diesem speziellen Beispiel von einer parasitären Kapazität von 1 uF pro Anschlussleitung und einem Widerstand von 5000kOhm bei einer Spannung des Batteriesystems von etwa 403 V ausgegangen wird.

Die Spannungsmessung wird für jede Anschlussleitung über eine vorgegebene Zeit von 7 Sekunden ausgeführt, wobei zunächst die positiven Pole 14 und anschließend die negativen Pole 16 gemessen werden, jeweils bei R0 (links) und sukzessive bei Nennwiderstand (rechts). Wie dargestellt mit der rechteckigen Kennzeichnung findet am Ende der jeweiligen Messung eine Spannungssättigung 20 statt, wobei zu diesem Zeitpunkt keine (relevante oder in einem vorgegebenen Toleranzbereich befindliche) Spannungsänderung mehr gemessen wird. Aufgrund dieser Messungen und der erreichten Sättigungsspannung wird gemäß diesem Verfahren ein Widerstand berechnet, welcher für den Isolationszustand der Batterie kennzeichnend ist. Zu sehen ist, dass ein solches Verfahren bis zu 30 Sekunden erfordern kann. Abhängig von der geforderten Genauigkeit, dem Widerstand und der parasitären Kapazität kann die Messung auch noch länger dauern.

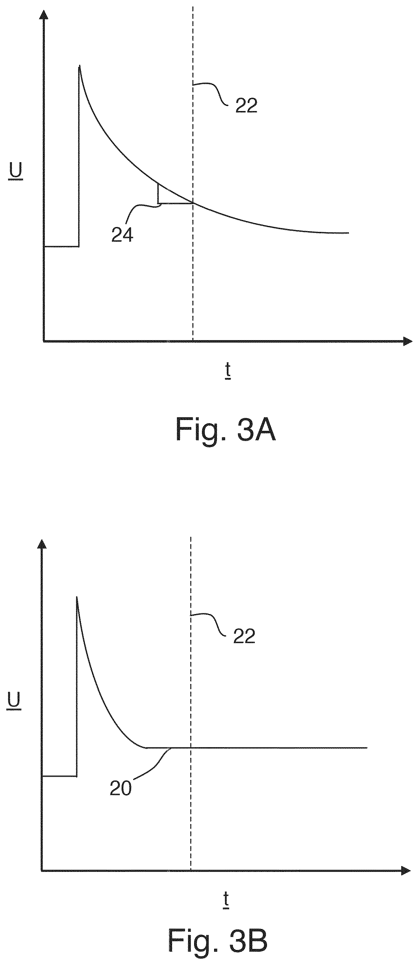

In den Figuren 3A und 3B ist schematisch der technische Vorteil des erfindungsgemäßen Überprüfungsverfahrens dargestellt. Basierend auf einer vorgegebenen parasitären Kapazität, welche bevorzugt für den jeweiligen Typ der Batterie gemessen und/oder berechnet wird, und einem vorgegebenen Widerstand, welcher für mindestens einen Isolationsfehler kennzeichnend ist, wird bei einer bekannten Spannung der Batterie ein zeitlicher Schwellenwert 22 bestimmt, bei dem beim Auftreten eines entsprechenden Isolationsfehlers eine Spannungssättigung eintreten sollte.

In Figur 3A ist ein Normalfall dargestellt, bei dem kein Isolationsfehler vorliegt. In diesem Fall wird zu dem Zeitpunkt, welcher dem zeitlichen Schwellenwert 22 entspricht, eine Spannungsänderung 24 dU/dt festgestellt. Daraus wird bestimmt, dass eine Spannungssättigung zu diesem Zeitpunkt noch nicht eingetreten ist, sodass ein (wesentlicher) Isolationsfehler ausgeschlossen werden kann. In diesem Fall kann ein Sicherheitssignal ausgegeben werden, welches auf einen fehlerfreien Zustand hindeutet und es kann beispielsweise ein Betätigungssignal für eine Hochspannungsschaltvorrichtung ausgegeben werden, um diese zu schließen und eine elektrisch leitfähige Verbindung zwischen der Batterie beziehungsweise dem Batteriesystem und einer Last wie einem Elektromotor bereitzustellen.

In Figur 3B liegt jedoch ein Isolationsfehler beziehungsweise eine geringe parasitäre Kapazität vor. Dadurch tritt die Spannungssättigung schnell ein - und zwar bevor der zeitliche Schwellenwert 22 erreicht und überschritten wurde. Mit anderen Worten wird zum Zeitpunkt des zeitlichen Schwellenwerts 22 keine Spannungsänderung festgestellt und es wird entsprechend ein Sicherheitssignal ausgegeben, welches auf einen vorliegenden Isolationsfehler hindeutet und/oder welches eine weitere, alternative Überprüfung des Isolationszustands veranlasst. Mit anderen Worten ist zum zeitlichen Schwellenwert 22 bereits eine Spannungssättigung 20 eingetreten.

Auf diese Weise wird eine schnelle Überprüfung des Isolationszustands ermöglicht, welche die Wartezeit für den Benutzer gegenüber widerstandsbasierte Überprüfungsverfahren erheblich verringert.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezugszeichenliste

- 1: Batteriesystem
- 10: Batterie
- 12: Anschlussleitung oder Anschlusselement
- 14: Positiver Pol
- 16: Negativer Pol
- 18: Chassis oder Masse
- 20: Spannungssättigung
- 22: Zeitlicher Schwellenwert
- 24: Spannungsänderung
- U: Spannung (V)
- t: Zeit (s)

## Patentansprüche

1. Verfahren zum Überprüfen eines Isolationszustands einer Batterie (10) oder eines mindestens zwei Batterien (10) umfassenden Batteriesystems (1), bevorzugt einer Hochspannungsbatterie oder eines Hochspannungsbatteriesystems zur Verwendung als Traktionsbatterie eines elektrischen Fahrzeugs oder zur Verwendung in stationären Speicheranwendungen, umfassend die Schritte:
- Messen einer elektrischen Spannung, U, zwischen einem Anschlusselement (12) der Batterie (10) und einer Masse (18) über eine vorgegebene Zeit, t;
- Auswerten der gemessenen Spannung (U) und feststellen, ob zu einem Zeitpunkt, welcher einem vorgegebenen zeitlichen Schwellenwert (22) entspricht, eine gemessene Spannungsänderung dU/dt (24) vorliegt; und
- Ausgeben eines für den Isolationszustand kennzeichnenden Sicherheitssignals in Abhängigkeit des Feststellungsergebnisses.

2. Verfahren gemäß Anspruch 1, **dadurch gekennzeichnet, dass** mindestens zwei Anschlusselemente (12) vorgesehen sind und das Verfahren für jedes Anschlusselement (12) der Batterie (10) ausgeführt wird.

3. Verfahren gemäß Anspruch 1 oder 2, **dadurch gekennzeichnet, dass** der zeitliche Schwellenwert (22) von einer parasitären Kapazität der Batterie (1) oder des Batteriesystems (1) und einem Widerstand der Batterie (10) oder des Batteriesystems (1) bestimmt wird.

4. Verfahren gemäß Anspruch 3, **dadurch gekennzeichnet, dass** die parasitäre Kapazität für einen Batterietyp oder eine Batteriekonfiguration festgelegt wird.

5. Verfahren gemäß Anspruch 3 oder 4, **dadurch gekennzeichnet, dass** die parasitäre Kapazität für die Batterie (10) oder das Batteriesystem (1) gemessen und/oder berechnet wird, wobei die parasitäre Kapazität zur Bestimmung des zeitlichen Schwellenwerts bevorzugt um einen vorgegebenen Sicherheitsfaktor erhöht wird.

6. Verfahren gemäß einem der Ansprüche 3 bis 5, **dadurch gekennzeichnet, dass** der Widerstand zwischen 50 kOhm und 250 kOhm liegt, bevorzugt zwischen 75 kOhm und 175 kOhm.

7. Verfahren gemäß einem der Ansprüche 3 bis 6, **dadurch gekennzeichnet, dass** der Widerstand ein Anfangswiderstand oder ein Nennwiderstand ist, welcher einem vorgegebenen Betriebszustand entspricht.

8. Verfahren gemäß einem der vorstehenden Ansprüche, **dadurch gekennzeichnet, dass** die Spanungsänderung (24) für die letzten zwei bis fünf Messpunkte bestimmt wird, bevorzugt die letzten zwei oder drei Messpunkte, und/oder wobei eine Spannungsänderung (24) bestimmt wird, wenn diese zumindest eine vorgegebene Mindestgröße aufweist.

9. Verfahren gemäß einem der vorstehenden Ansprüche, **dadurch gekennzeichnet, dass** das Sicherheitssignal weiterhin in Abhängigkeit eines zum Zeitpunkt gemessenen absoluten Spannungswerts (U) ausgegeben wird.

10. Verfahren gemäß einem der vorstehenden Ansprüche, **dadurch gekennzeichnet, dass** das Sicherheitssignal bei einer zum Zeitpunkt festgestellten Spannungsänderung (24) ein Betätigungssignal einer Hochspannungsschaltvorrichtung umfasst oder in Abwesenheit einer Spannungsänderung (24) eine weitere Isolationsüberprüfung veranlasst.

11. Überprüfungsmodul zum Überprüfen eines Isolationszustands einer Batterie (10) oder eines Batteriesystems (1), bevorzugt einer Traktionsbatterie eines elektrischen Fahrzeugs, welches dazu eingerichtet ist, das Verfahren nach einem der Ansprüche 1 bis 10 auszuführen.

12. Batteriesystem, umfassend mindestens zwei Batterien (10) und ein damit kommunikativ und/oder elektrisch leitfähig gekoppeltes Überprüfungsmodul gemäß Anspruch 11.

13. Batteriesystem gemäß Anspruch 12, umfassend eine Hochspannungsschaltvorrichtung, welche dazu eingerichtet ist, in Abhängigkeit eines vom Überprüfungsmodul ausgegebenen Sicherheitssignals jede Batterie zuzuschalten.

## Claims

1. A method for checking an insulation state of a battery (10) or battery system (1) comprising at least two batteries (10), preferably a high-voltage battery or high-voltage battery system for use as traction battery of an electric vehicle or for use in static storage applications, comprising the following steps:
- measuring a voltage (U) between a connection element (12) of the battery (10) and a ground (18) over a predefined time, t;
- evaluating the measured voltage (U) and determining whether a measured voltage change dU/dt (24) is present at a time point that corresponds to a predefined temporal threshold value (22); and
- outputting a safety signal characterizing the insulation state on the basis of the determined result.

2. The method as claimed in claim 1, **characterized in that** at least two connection elements (12) are provided and the method is carried out for each connection element (12) of the battery (10).

3. The method as claimed in claim 1 or 2, **characterized in that** the temporal threshold value (22) is defined by a parasitic capacitance of the battery (10) or battery system (1) and a resistance of the battery (10) or battery system (1).

4. The method as claimed in claim 3, **characterized in that** the parasitic capacitance is defined in a battery-specific manner.

5. The method as claimed in claim 3 or 4, **characterized in that** the parasitic capacitance is measured and/or computed for the battery (10) or the battery system (1), wherein the parasitic capacitance is preferably increased by a predefined safety factor for determining the temporal threshold value.

6. The method as claimed in one of claims 3 to 5, **characterized in that** the resistance is between 50 kOhm and 250 kOhm, preferably between 75 kOhm and 175 kOhm.

7. The method as claimed in one of claims 3 to 6, **characterized in that** the resistance is a starting resistance or a nominal resistance that corresponds to a predefined operating state.

8. The method as claimed in one of the preceding claims, **characterized in that** the voltage change (24) is determined for the last two to five measurement points, preferably the last two or three measurement points, and/or wherein a voltage change (24) is determined when this has at least one predefined minimum magnitude.

9. The method as claimed in one of the preceding claims, **characterized in that** the safety signal is furthermore output on the basis of an absolute voltage value (U) measured at the time point.

10. The method as claimed in one of the preceding claims, **characterized in that**, in the event of a voltage change (24) determined at the time point, the safety signal comprises an actuation signal for a high-voltage switching device or, in the absence of a voltage change (24), initiates a further insulation check.

11. A checking module for checking an insulation state of a battery (10) or battery system (1), preferably a traction battery of an electric vehicle, wherein the checking module is configured to carry out the method as claimed in one of claims 1 to 10.

12. A battery system comprising at least two batteries (10) and a checking module as claimed in claim 11 communicatively and/or electrically conductively coupled thereto.

13. The battery system as claimed in claim 12 comprising a high-voltage switching device that is configured to connect each battery on the basis of a safety signal output by the checking module.

## Revendications

1. Procédé de vérification d'un état d'isolation d'une batterie (10) ou d'un système de batterie (1) comprenant au moins deux batteries (10), de préférence d'une batterie haute tension ou d'un système de batterie haute tension destiné à être utilisé en tant que batterie de traction d'un véhicule électrique ou destiné à être utilisé dans des applications de stockage stationnaires, comprenant les étapes suivantes :
- mesure d'une tension électrique, U, entre un élément de raccordement (12) de la batterie (10) et une masse (18) pendant un temps prédéfini, t ;
- évaluation de la tension mesurée (U) et constatation de la présence d'une variation de tension mesurée dU/dt (24) à un moment qui correspond à une valeur seuil temporelle prédéfinie (22) ; et
- émission d'un signal de sécurité caractérisant l'état d'isolation en fonction du résultat de la constatation.

2. Procédé selon la revendication 1, **caractérisé en ce qu'**au moins deux éléments de raccordement (12) sont prévus et le procédé est réalisé pour chaque élément de raccordement (12) de la batterie (10).

3. Procédé selon la revendication 1 ou 2, **caractérisé en ce que** la valeur seuil temporelle (22) est déterminée par une capacité parasite de la batterie (1) ou du système de batterie (1) et une résistance de la batterie (10) ou du système de batterie (1).

4. Procédé selon la revendication 3, **caractérisé en ce que** la capacité parasite est fixée pour un type de batterie ou une configuration de batterie.

5. Procédé selon la revendication 3 ou 4, **caractérisé en ce que** la capacité parasite est mesurée et/ou calculée pour la batterie (10) ou le système de batterie (1), la capacité parasite étant augmentée de préférence d'un facteur de sécurité prédéfini pour la détermination de la valeur seuil temporelle.

6. Procédé selon l'une quelconque des revendications 3 à 5, **caractérisé en ce que** la résistance est comprise entre 50 kOhm et 250 kOhm, de préférence entre 75 kOhm et 175 kOhm.

7. Procédé selon l'une quelconque des revendications 3 à 6, **caractérisé en ce que** la résistance est une résistance initiale ou une résistance nominale qui correspond à un état de fonctionnement prédéfini.

8. Procédé selon l'une quelconque des revendications précédentes, **caractérisé en ce que** la variation de tension (24) est déterminée pour les deux à cinq derniers points de mesure, de préférence les deux ou trois derniers points de mesure, et/ou une variation de tension (24) étant déterminée lorsque celle-ci présente au moins une grandeur minimale prédéfinie.

9. Procédé selon l'une quelconque des revendications précédentes, **caractérisé en ce que** le signal de sécurité est en outre émis en fonction d'une valeur de tension absolue (U) mesurée au moment.

10. Procédé selon l'une quelconque des revendications précédentes, **caractérisé en ce que** le signal de sécurité comprend, dans le cas d'une variation de tension (24) constatée au moment, un signal d'actionnement d'un dispositif de commutation à haute tension ou, en l'absence d'une variation de tension (24), déclenche un autre contrôle d'isolation.

11. Module de vérification pour vérifier un état d'isolation d'une batterie (10) ou d'un système de batterie (1), de préférence d'une batterie de traction d'un véhicule électrique, lequel est conçu pour mettre en oeuvre le procédé selon l'une quelconque des revendications 1 à 10.

12. Système de batterie, comprenant au moins deux batteries (10) et un module de vérification selon la revendication 11 couplé à celles-ci de manière communicative et/ou électriquement conductrice.

13. Système de batterie selon la revendication 12, comprenant un dispositif de commutation à haute tension, lequel est conçu pour connecter chaque batterie en fonction d'un signal de sécurité émis par le module de vérification.
